(19) Europäisches Patentamt / European Patent Office / Office européen des brevets

(11) **EP 3 465 240 B1**

(12) **FASCICULE DE BREVET EUROPEEN**

(45) Date de publication et mention de la délivrance du brevet:
**15.04.2020 Bulletin 2020/16**

(21) Numéro de dépôt: **17730862.4**

(22) Date de dépôt: **19.05.2017**

(51) Int Cl.:
***G01R 31/36*** *(2020.01)*

(86) Numéro de dépôt international:
**PCT/FR2017/051238**

(87) Numéro de publication internationale:
**WO 2017/207891 (07.12.2017 Gazette 2017/49)**

(54) **PROCEDE D'ESTIMATION DE L'ETAT DE SANTE D'UNE BATTERIE**

VERFAHREN ZUR SCHÄTZUNG DES GESUNDHEITSZUSTANDS EINER BATTERIE

METHOD FOR ESTIMATING THE STATE OF HEALTH OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.05.2016 FR 1654898**

(43) Date de publication de la demande:
**10.04.2019 Bulletin 2019/15**

(73) Titulaire: **Renault S.A.S.**
**92100 Boulogne-Billancourt (FR)**

(72) Inventeurs:
• **MENSLER, Michel**
**78180 MONTIGNY-LE-BRETONNEUX (FR)**
• **DRIEMEYER-FRANCO, Ana-Lucia**
**78180 MONTIGNY-LE-BRETONNEUX (FR)**

(56) Documents cités:
| | |
|---|---|
| **EP-A1- 2 233 937** | **EP-A2- 2 098 878** |
| **WO-A1-2015/180743** | **WO-A2-2012/166489** |
| **CN-A- 105 319 515** | **FR-A1- 3 009 093** |
| **JP-A- 2016 070 682** | **JP-B2- 5 242 997** |
| **US-A1- 2013 271 148** | **US-A1- 2016 131 720** |

**Description**

*DOMAINE DE L'INVENTION*

L'invention se rapporte au domaine général des systèmes électriques alimentés par des batteries d'accumulateurs.

Elle concerne plus particulièrement les batteries alimentant des véhicules électriques et s'intéresse aux moyens de connaitre à un instant donné l'état de santé de telles batteries.

*CONTEXTE DE L'INVENTION - ART ANTERIEUR*

Dans le cadre de l'utilisation de batteries comme source d'énergie pour alimenter un véhicule automobile, il est important de pouvoir déterminer à tout moment l'état de santé de ces batteries, considéré en termes d'énergie et de puissance disponibles.

Par état de santé d'une batterie, ou "State Of Health Energy" (SOHE) selon la dénomination anglo-saxonne, on entend un indicateur rendant compte du niveau de dégradation de la batterie, estimé à l'instant considéré, du fait notamment de l'âge de la batterie et des conditions d'utilisation de cette dernière.

Le SOHE constitue ainsi un paramètre permettant de quantifier le niveau d'énergie disponible dans la batterie une fois celle-ci chargée à son plein potentiel, en tenant compte de la dégradation des performances de la batterie au cours de son cycle de vie.

Cette dégradation se traduit pour l'utilisateur par une plus faible puissance disponible et par une plus faible autonomie, dont l'utilisateur a tout intérêt à être informé de manière la plus précise possible.

La valeur SOHE peut être calculée par diverses méthodes permettant d'évaluer l'évolution au cours du temps des performances de la batterie considérée.

On distingue ainsi deux types d'estimations :

- les estimations dites prédictives, basées sur l'utilisation d'un modèle théorique de dégradation de l'état de santé de la batterie faisant intervenir des mesures de temps cumulé représentant le temps passé par la batterie dans différentes conditions de températures et différents états de charge ainsi que des mesures de l'énergie déchargée de la batterie (i.e. fournie par la batterie) pour ces mêmes différentes conditions.
- les estimations dites par calcul direct, basées sur la mesure d'une ou plusieurs grandeurs dynamiques relatives au comportement électrique de la batterie. Ces estimations peuvent par exemple consister dans la mesure du courant circulant dans la batterie durant les cycles successifs de charge et de décharge de façon à déterminer la capacité de la batterie à l'instant considéré, ou encore sur le calcul de la résistance interne de la batterie à partir de mesures de tension et de courant.

Ces deux types d'estimations de l'état de santé SOHE(k) d'une batterie à un instant k donné présentent chacun des avantages propres en termes de précision de l'estimation réalisée. La précision de l'estimation obtenue par l'emploi d'une méthode appartenant à l'un ou l'autre de ces deux types n'est cependant pas constante au cours de la durée de vie de la batterie.

De manière générale, une méthode d'estimation du premier type s'avère notamment plus précise en début de vie de la batterie alors qu'une méthode d'estimation du second type est plus précise après une période d'utilisation donnée de la batterie.

Par suite, pour obtenir une estimation de l'état de santé d'une batterie présentant une précision satisfaisante tout au long de la vie de la batterie, une approche connue consiste à combiner le plus judicieusement possible les résultats fournis par deux estimations distinctes appartenant chacune à un type d'estimation. Cette combinaison prend la forme d'une somme pondérée de valeurs du SOHE, obtenues en mettant en œuvre ces deux méthodes. La valeur de l'estimation du SOHE de la batterie pour un instant k donnée a alors pour expression générale:

$$SOHE(k) = \alpha_1 \cdot SOHE_1 + \alpha_2 \cdot SOHE_2 \qquad [1]$$

Où $SOHE_1$ et $SOHE_2$ correspondent respectivement aux deux méthodes d'estimation utilisées, chaque estimation étant d'un type différent de l'autre, et où $\alpha_1$ et $\alpha_2$ sont des coefficients de pondération.

Cependant, dans la mesure où la précision de l'estimation fournie par chaque méthode varie au cours du temps, en fonction notamment de l'âge de la batterie et de la façon dont celle-ci est utilisée, les coefficients de pondération affectés à chacune des méthodes mise en œuvre doivent varier au cours du temps de façon à attribuer aux résultats obtenus par chaque méthode un poids qui reflète la précision attendue de la méthode à l'instant considéré.

Il existe à ce jour, plusieurs façons de déterminer la valeur des coefficients de pondérations $\alpha_1$ et $\alpha_2$ utilisés pour réaliser cette somme pondérée des deux estimations.

De manière connue, les valeurs des coefficients de pondération affectés aux estimations réalisées évoluent généralement au cours du temps de telle façon que l'estimation obtenue par la méthode du premier type, initialement affectée d'une pondération plus élevée que celle affectée à la méthode du second type et prépondérante dans l'estimation globale, diminue progressivement, tandis que l'estimation obtenue par la méthode du second type, initialement affectée d'une pondération faible, augmente progressivement, en fonction de l'âge de la batterie, jusqu'à devenir prépondérante dans l'estimation globale.

La demande de brevet français FR3009093 décrit un procédé d'estimation de l'état de vieillissement d'une batterie électrique qui met en œuvre une combinaison barycentrique (i.e. une somme pondérée) combinant une estimation réalisée à partir d'un modèle d'évolution de l'état de santé de la batterie et une estimation réalisée à partir d'un estimateur par calcul direct prenant en comptes des mesures relatives au fonctionnement de la batterie.

Cependant, la pondération mise en œuvre est ici une pondération empirique qui est simplement évolutive avec le temps, l'estimation par le modèle restant d'un poids prépondérant constant pendant un laps de temps donné de la vie de la batterie puis diminuant de manière régulière ensuite, tandis que le poids donné à l'estimateur par calcul direct devient en proportion de plus en plus important. Par suite, si le calcul des coefficients appliqués dans le cadre de cette demande de brevet prend bien en compte le facteur temps, il ne prend généralement pas en compte la justesse de l'estimation réalisée notamment par l'estimation par calcul direct (second type).

Le document JP2016070682A décrit un procédé pour déterminer l'état de santé SOHE d'une batterie. Il présente des inconvénients similaires aux inconvénients précités.

***PRESENTATION DE L'INVENTION***

Un but de l'invention est de proposer une estimation de l'état de vieillissement d'une batterie équipant un véhicule électrique ou hybride qui soit précise sur toute la durée de vie de la batterie et qui prenne en compte les habitudes de conduite du conducteur.

Un autre but de l'invention est de proposer une estimation de l'état de vieillissement d'une batterie équipant un véhicule électrique ou hybride qui permette de prendre en compte la précision des mesures utilisées pour réaliser cette estimation, notamment pour réaliser l'estimation par calcul direct.

A cet effet l'invention a pour objet un procédé pour estimer, à un instant k, l'état de santé SOHE(k) d'une batterie d'accumulateurs installée dans un équipement et destinée à alimenter ledit équipement en énergie électrique, selon la revendication 1. Selon ledit procédé, la valeur SOHE(k) est déterminée par la relation suivante:

$$ \text{SOHE}(k) = \text{SOHE}_{\text{modèle}}(T) - \alpha_{\text{ic}}(T) \cdot \left( \text{SOHE}_{\text{modèle}}(T) - \text{SOHE}_{\text{Algorithme}}(T) \right) $$

où :

- $\text{SOHE}_{\text{modèle}}$ est un modèle d'évolution au cours du temps de l'état de santé de la batterie à partir d'un état de santé à un instant initial ;
- $\text{SOHE}_{\text{Algorithme}}$ est un estimateur permettant de déterminer l'état de santé de la batterie à tout instant, à partir de mesures de grandeurs électriques relatives au fonctionnement de la batterie faites audit instant, l'instant T étant un instant de recalage, antérieur à l'instant k;
- le coefficient $\alpha_{\text{ic}}(T)$ est l'indice de confiance attribué à la valeur fournie par l'estimateur $\text{SOHE}_{\text{Algorithme}}$ à l'instant T de recalage.

Selon diverses dispositions pouvant être considérées seules ou en combinaison, le procédé selon l'invention peut présenter diverses caractéristiques. Ainsi :

- Selon une caractéristique, $\text{SOHE}_{\text{modèle}}$ est défini pour tout instant k par la relation suivante:

$$ \text{SOHE}_{\text{modèle}}(k) = \text{SOHE}_{\text{init}}(0) - \text{dégradation}(k) $$

dans laquelle le terme $\text{SOHE}_{\text{init}}(0)$ correspond à l'état de santé de la batterie à l'instant initial et le terme dégradation(k) correspond à l'altération, à l'instant k, de l'état de santé de la batterie par rapport à l'état de santé à l'instant initial.
- Selon une autre caractéristique, le terme dégradation(k) est défini par la relation suivante:

$$\text{dégradation(k)} = \left( \sum_{i=1}^{P} \sum_{j=1}^{Q} \alpha_{i,j}^{\frac{1}{n}} * t_{i,j}(k) \right)^n + \left( \sum_{i=1}^{P} \sum_{j=1}^{Q} \beta_{i,j}^{\frac{1}{m}} * e_{i,j}(k) \right)^m$$

où les indices i et j sont associés respectivement à P valeurs de température de la batterie dans P états et à Q valeurs d'état de charge dans Q états, les couples (i, j) constituant P.Q états (température, état de charge); où $t_{i,j}$ est le laps de temps passé par la batterie, entre l'instant initial et l'instant k considéré, dans l'état (i, j) et où $e_{i,j}$ est l'énergie déchargée par la batterie, entre ce même instant initial et l'instant k, dans ce même état (i, j); les valeurs $t_{i,j}$ et $e_{i,j}$ étant réactualisées de manière périodique, depuis l'instant initial, durant les périodes où la batterie est en décharge.

- Selon une autre caractéristique, $SOHE_{Algorithme}(k)$ est défini par la relation suivante:

$$SOHE_{Algorithme} = \frac{1}{Q_{BOL}} \frac{\left| \int_{t1}^{t2} I \, dt \right|}{|SOC_2 - SOC_1|}$$

où I représente le courant traversant la batterie, t1 et t2 respectivement les instants de début et de fin de mesure de I et SOC1 et SOC2 l'état de charge de la batterie aux instants respectifs t1 et t2; QBOL représentant la capacité de la batterie à l'état neuf.
- Selon une autre caractéristique, les états de charge SOC1 et SOC2 de la batterie aux instants respectifs t1 et t2 sont calculés soit à partir de mesures OCV1 et OCV2 de la tension à vide aux bornes de la batterie aux instants respectifs t1 et t2, lesdites mesures étant réalisées après une période d'inactivité de la batterie, soit par une estimation de l'état de charge par un estimateur.

Par ailleurs, selon le procédé selon l'invention, le coefficient $\alpha_{ic}$ est défini à l'instant k par la relation suivante:

$$\alpha_{ic}(k) = f\left( \frac{dSOHE_{Algorithme}}{SOHE_{Algorithme}} \right)$$

où $dSOHE_{Algorithme}$ correspond à l'erreur théorique commise sur le calcul de $SOHE_{Algorithme}$ compte tenu de la précision des capteurs de mesures utilisés.
Selon d'autres dispositions pouvant être considérées seules ou en combinaison, le procédé selon l'invention peut présenter diverses caractéristiques. Ainsi :

- Selon une caractéristique, le coefficient $\alpha_{ic}$ est choisi de façon à prendre en compte au moins l'un des critères suivants :

    a) plus l'erreur théorique est grande, plus $\alpha_{ic}$ est petit, $\alpha_{ic}$ étant une fonction décroissante de l'erreur;
    b) pour une erreur supérieure à une limite donnée, $\alpha_{ic}$ est forcé à zéro;
    c) tant que certaines conditions données, relatives aux mesures prises en compte dans l'estimation par calcul direct, ne sont pas remplies, $\alpha_{ic}$ est forcé à zéro, de façon à ce que l'estimateur ne soit pas pris en compte pour le calcul de SOHE.

- Selon une autre caractéristique, les instants de recalage T sont des instants particuliers pour lesquels une condition portant sur la valeur de $\alpha_{ic}(T)$ est remplie, indiquant que l'erreur théorique d'estimation réalisée par l'estimateur $SOHE_{Algorithme}$ est faible.
- Selon une autre caractéristique, tout instant d'estimation étant considéré comme un instant de recalage, SOHE(k) est défini par la relation suivante:

$$SOHE(k) = (1 - \alpha_{ic}(k)) \cdot SOHE_{Modèle}(k) + \alpha_{ic}(k) \cdot SOHE_{Algorithme}(k)$$

- Selon une autre caractéristique, SOHE(k) est défini, par la relation suivante:

$$SOHE(k) = SOHE_{modèle}(k) - SOHE_{modèle}(T) + SOHE_{Algorithme}(T);$$

les instants T étant des instants pour lesquels $\alpha_{ic}(T)$ est supérieur à une valeur de recalage $\lim_{recal}$ donnée.

Le procédé selon l'invention propose ainsi pour le calcul de la pondération, une méthode théorique basée sur l'indice de confiance de l'estimateur.

Avantageusement, le procédé selon l'invention permet de corriger de façon durable un mauvais calcul du modèle puisque celui-ci est recalé de manière systématique, au moment où l'estimation est bonne c'est-à-dire lorsque les conditions voulues sont réunies.

Avantageusement encore, le procédé selon l'invention apparait comme étant facile à mettre en œuvre, sans coût additionnel (informations déjà disponibles avec les capteurs actuels, modèle de dégradation déjà connu).

## DESCRIPTION DETAILLEE

Comme d'autre procédés connus, le procédé selon l'invention propose de réaliser une estimation de l'état de santé SOHE d'une batterie en réalisant séparément deux estimations de cet état de santé par deux méthodes différentes, en effectuant une somme pondérée de ces deux estimations.

De même, comme d'autres procédés connus, les deux estimations sont réalisées d'une part par un modèle de prédiction $SOHE_{Modèle}$ et d'autre part par un estimateur par calcul direct $SOHE_{Algorithme}$.

Cependant, à la différence des estimations connues, la pondération est ici réalisée à partir d'un même indicateur $\alpha_{IC}$ qui représente un indice de confiance de l'estimateur par calcul direct $SOHE_{Algorithme}$ à l'instant considéré.

Dans la suite du texte, on précise la manière dont cet indice de confiance peut être calculé et comment l'utilisation de cet indice de confiance modifie l'expression générale de l'estimateur SOHE(k) de l'état de santé d'une batterie, expression générale réalisée à partir d'un estimateur prédictif $SOHE_{Modèle}$ et d'un estimateur par calcul direct $SOHE_{Algorithme}$.

Le modèle de prédiction de la dégradation du SOHE d'une batterie, connu dans l'état de l'art, sur lequel se base le procédé selon l'invention, peut être exprimé de manière générale, à partir d'un état de santé initial $SOHE_{init}$, comme suit:

$$SOHE_{modèle}(k) = SOHE_{init}(0) \text{-dégradation}(k) \qquad [2]$$

où k représente un instant donné correspondant par exemple à un début de cycle de fonctionnement donné de la batterie en charge ou en décharge.

Le terme "dégradation(k)" correspond quant à lui à la perte d'efficacité de la batterie. Il peut être exprimé par la relation suivante:

$$\text{dégradation}(k) = \left( \sum_{i=1}^{5} \sum_{j=1}^{5} \alpha_{i,j}^{\frac{1}{n}} * t_{i,j}(k) \right)^{n} + \left( \sum_{i=1}^{5} \sum_{j=1}^{5} \beta_{i,j}^{\frac{1}{m}} * e_{i,j}(k) \right)^{m}$$

$$[3]$$

où i et j représentent respectivement une valeur de température quantifiée sur 5 états, ou plus généralement sur P états et une valeur d'état de charge quantifiée sur 5 états, ou plus généralement sur Q états, les couples (i, j) constituant des états (température, état de charge) référencés.

$t_{i,j}$ représente ici le laps de temps passé par la batterie, entre un instant initial et l'instant k considéré, dans l'état (i, j) et $e_{i,j}$ l'énergie déchargée par la batterie, entre ce même instant initial et l'instant k, dans ce même état (i, j).

L'instant initial correspond, de préférence, à un instant voisin de l'instant de première mise en service de la batterie ou bien, idéalement, à cet instant même.

Ces valeurs $t_{i,j}$ et $e_{i,j}$ sont réactualisées de manière périodique, depuis l'instant initial de mise en service de la batterie, durant les périodes où la batterie est en décharge.

Elles sont préférentiellement stockées dans le système de contrôle du fonctionnement de la batterie (BMS ou Battery Management System selon la dénomination anglo-saxonne).

Les coefficients $\alpha_{i,j}$ sont des coefficients de pondération réels, prédéterminés de manière expérimentale de façon à ce que le terme "dégradation(k) soit représentatif de l'évolution de la dégradation de la batterie au cours du temps, dégradation notamment fonction du mode de fonctionnement imposé à la batterie par l'utilisateur du véhicule.

Les coefficients $\alpha_{i,j}$ sont également stockés en table au niveau du BMS.

Les valeurs des exposants n et m sont, quant à elles, des valeurs (réelles) comprises (typiquement) entre 0 et 1, déterminées également de manière expérimentale.

L'estimateur par calcul direct de la dégradation du SOHE d'une batterie sur lequel se base le procédé selon l'invention peut être, quant à lui, exprimé de manière générale, à partir de la capacité de la batterie à l'état neuf QBOL, comme suit:

$$SOHE_{Algorithme} = \frac{1}{Q_{BOL}} \frac{\left|\int_{t1}^{t2} I\, dt\right|}{|SOC_2 - SOC_1|} \qquad [4]$$

où I représente le courant batterie et $t_1$ et $t_2$ respectivement les instants de début et de fin de mesure de I.

$SOC_1$ représente l'état de charge de la batterie à l'instant $t_1$ et $SOC_2$ l'état de charge à l'instant $t_2$.

$Q_{BOL}$ représente ici la capacité de la batterie à l'état neuf ou état BOL ("Begin Of Life") selon la dénomination anglo-saxonne.

t1, instant de début de calcul, correspond typiquement à un instant de changement de mode de fonctionnement de la batterie (charge vers décharge ou inversement) tandis que t2 est un instant défini par ailleurs, qui peut correspondre à l'instant de fin de la phase de fonctionnement débutée à l'instant t1.

Le calcul de $SOHE_{Algorithme}$ repose ici sur un principe similaire à celui de la procédure dite de check-up d'une batterie, selon laquelle les valeurs de SOC1 et de SOC2, qui expriment un pourcentage de capacité disponible restant à utiliser à un instant donné, peuvent être calculées à partir de la valeur de la tension à vide de la batterie aux instants t1 et t2 considérés (OCV1 et OCV2). Cette valeur peut être directement mesurée après une période de repos (inactivité de la batterie), ou résulter d'une estimation de SOC par une méthode comme le filtrage de Kalman par exemple. Ainsi, en fonction de la possibilité ou non de disposer d'états de repos permettant d'effectuer les mesures de tension à vide $OCV_1$ et $OCV_2$, $SOHE_{Algorithme}$ peut être défini en pratique sous différentes formes:

$$SOHE_{Algorithme} = \frac{1}{Q_{BOL}} \cdot \frac{\left|\int_{t_1}^{t_2} I\, d\tau\right|}{|f(OCV_2) - f(OCV_1)|} \qquad [5]$$

$$SOHE_{Algorithme} = \frac{1}{Q_{BOL}} \cdot \frac{\left|\int_{t_1}^{t_2} I\, d\tau\right|}{|SOC_2(EKF) - f(OCV_1)|} \qquad [6]$$

$$SOHE_{Algorithme} = \frac{1}{Q_{BOL}} \cdot \frac{\left|\int_{t_1}^{t_2} I\, d\tau\right|}{|f(OCV_2) - SOC_1(EKF)|} \qquad [7]$$

$$SOHE_{Algorithme} = \frac{1}{Q_{BOL}} \cdot \frac{\left|\int_{t_1}^{t_2} I\, d\tau\right|}{|SOC_2(EKF) - SOC_1(EKF)|} \qquad [8]$$

Il est cependant à noter que, tel qu'il est exprimé, le calcul de $SOHE_{Algorithme}$ suppose une approximation de l'état de santé SOHE de la batterie, normalement défini par la relation suivante :

$$SOHE \triangleq \frac{E}{E_0} \times 100 \qquad [9]$$

où E est l'énergie en [Wh] lorsque la batterie est complètement chargée et Eo est l'énergie en [Wh] lorsque la batterie est complètement chargée et à l'état neuf (début de vie). Cette définition est établie pour une température de 25°C.

Dans le cas présent on considère, à la place, la relation suivante :

$$SOHE \triangleq \frac{Q}{Q_0} \times 100 \qquad [10]$$

où Q est la capacité en [Ah] de la batterie, Qo est la capacité à l'état neuf ou BOL (Begin Of Life). Cette définition est établie à une température de 25°C.

Cette approximation conduit à une erreur sur le calcul du $SOHE_{Algorithme}$ de l'ordre de 0% à 5%, cette erreur étant fonction de l'augmentation de la résistance interne de la batterie et du régime de décharge.

A la différence des procédés connus, le procédé selon l'invention se base en outre également sur l'utilisation d'un indice de confiance de l'estimateur $SOHE_{Algorithme}$, obtenu par le calcul de l'erreur théorique résultant des erreurs de mesure (capteur courant, capteur tension, estimation SOC), erreur qui peut être formulée comme suit:

$$E\left(SOHE_{Algorithme}\right) = \frac{dSOHE_{Algorithme}}{SOHE_{Algorithme}} = \frac{d\int_{t_1}^{t_2} I d\tau}{\int_{t_1}^{t_2} I d\tau} + \frac{-dSOC_1}{\Delta SOC} + \frac{dSOC_2}{\Delta SOC} \quad [11]$$

et qui peut être bornée par une erreur maximal donnée par

$$E_{Max}\left(SOHE_{Algorithme}\right) \approx \left| \frac{d\int_{t_1}^{t_2} I d\tau}{\int_{t_1}^{t_2} I d\tau} \right| + \left| \frac{dSOC_1}{\Delta SOC} \right| + \left| \frac{dSOC_2}{\Delta SOC} \right| \qquad [12]$$

Ainsi, par exemple, s'il est possible de disposer d'états de repos permettant d'effectuer les mesures de tension à vide $OCV_1$ et $OCV_2$, l'erreur maximale $E_{Max}(SOHE_{Algorithme})$ est donnée par la relation suivante:

$$E_{Max}\left(SOHE_{Algorithme}\right) \approx \left| \frac{d\int_{t_1}^{t_2} I d\tau}{\int_{t_1}^{t_2} I d\tau} \right| + \left| \frac{\text{erreur tension} \cdot \frac{dSOC_1}{dOCV}}{\Delta SOC} \right| + \left| \frac{\text{erreur tension} \cdot \frac{dSOC_2}{dOCV}}{\Delta SOC} \right|$$

$$[13]$$

Selon l'invention, cet indice de confiance de l'estimateur par calcul direct est mis à profit pour effectuer un recalage de la valeur de l'estimation fournie par le modèle de prédiction SOHEModèle, recalage basé sur la valeur de cette erreur.

Pour ce faire, l'expression de SOHEModèle est formulée de la façon suivante:

$$SOHE_{Modèle}(k) = SOHE_{modèle}(T) - (degradation(k) - degradation(T))$$

$$[14]$$

Où le terme "dégradation(T)" est égale à la valeur de la fonction "dégradation(k)" pour k=T, T étant un instant particulier appelé instant de recalage, et où $SOHE_{modèle}(T)$ est égal à $SOHE_{Modèle}(k)$ pour k=T.

Puis le terme $SOHE_{modèle}(T)$ est remplacé par un terme $SOHE_{recal}(T)$ ayant pour expression:

$$SOHE_{Recal}(T) = (1 - \alpha_{ic}(T)) \cdot SOHE_{Modèle}(T) + \alpha_{ic}(T) \cdot SOHE_{Algorithme}(T)$$

$$[15]$$

où $\alpha_{ic}$ représente un coefficient transcrivant l'indice de confiance de l'estimateur $SOHE_{Algorithme}$:

$$\alpha_{ic}(k) = f\left(\frac{dSOHE_{Algorithme}}{SOHE_{Algorithme}}\right) \qquad [16]$$

Par suite, l'expression générale de l'estimateur SOHE(k) de l'état de santé d'une batterie, tel qu'il est déterminé au moyen du procédé selon l'invention, est donnée par l'expression finale:

$$\mathrm{SOHE}(k) = \mathrm{SOHE}_{\mathrm{Recal}}(T) - (\mathrm{degradation}(k) - \mathrm{degradation}(T)) \quad [17]$$

Ou bien, de manière équivalente, par l'expression:

$$\mathrm{SOHE}(k) = \mathrm{SOHE}_{\mathrm{modèle}}(k) - \alpha_{ic}(T) \cdot \left(\mathrm{SOHE}_{\mathrm{modèle}}(T) - \mathrm{SOHE}_{\mathrm{Algorithme}}(T)\right)$$
$$[18]$$

Ainsi, si l'indice de confiance attribué à l'estimation pour un instant k donné est nul, $\mathrm{SOHE}_{\mathrm{Recal}}(k)$ sera égal à $\mathrm{SOHE}_{\mathrm{modèle}}(k)$ et aucun recalage ne sera effectué pour cet instant.
En revanche si l'indice de confiance attribué à l'estimation pour un instant k donné est maximal, cet instant K devient un instant de recalage T pour lequel $\mathrm{SOHE}_{\mathrm{Recal}}(T)$ est sensiblement égal à $\mathrm{SOHE}_{\mathrm{Algorithme}}(T)$
Selon l'invention, le coefficient $\alpha_{ic}(k)$ est choisi de façon à prendre en compte les critères suivants :

- Plus l'erreur théorique est grande, plus l'indice de confiance $\alpha_{ic}(k)$ est petit ($\alpha_{ic}(k)$ fonction décroissante de l'erreur);
- pour une erreur supérieure à une certaine limite, l'indice de confiance $\alpha_{ic}(k)$ est forcé à zéro;

Selon la forme de mise en œuvre du procédé selon l'invention, Il est possible également, que l'indice de confiance $\alpha_{ic}(k)$ soit forcé à zéro, de façon à ce que l'estimateur ne soit pas pris en compte si certaines conditions ne sont pas remplies (par exemple, une condition de température, de type de profil, de valeur de courant, etc...), dans ces cas l'indice de confiance $\alpha_{ic}(k)$ est forcé à zéro.
Selon l'invention, les instants de recalage T sont donc des instants k particuliers, pour lesquels l'algorithme a réalisé une bonne estimation. Par bonne estimation, on entend une estimation pour laquelle une condition de valeur de $\alpha_{ic}(k)$ est remplie et donc pour laquelle l'erreur théorique d'estimation est faible.
Selon la forme de mise en œuvre du procédé selon l'invention, Il est possible également, d'imposer que le recalage ait lieu uniquement lorsque l'estimation SOHE(k) donne des résultats assez proches les uns des autres un certain nombre des fois, sur une certaine période de temps, avec une erreur théorique faible. Il est par exemple possible, une estimation étant réalisée 3 fois en une semaine, de ne pratiquer un recalage que si on enregistre pour chaque estimation une erreur théorique inférieure à 2%, et un écart entre les valeurs estimées inférieur à 2%.
Par ailleurs, si d'autres facteurs sont importants, ils peuvent aussi être pris en compte. On peut par exemple choisir uniquement les estimations faites sur certaines plages de valeurs OCV-SOC, ou encore choisir que la méthode d'estimation du SOC utilisée utilise nécessairement l'OCV.
Il est à noter que, de manière alternative, l'estimation SOHE(k) peut être réalisée en considérant un estimateur simplifié par rapport à l'estimateur décrit par la relation [17]. La simplification peut notamment prendre deux formes distinctes décrites ci-après.
Selon une première variante du procédé selon l'invention, SOHE(k) est estimé en ne considérant que $\mathrm{SOHE}_{\mathrm{Recal}}$ tel que défini par la relation [15], $\mathrm{SOHE}_{\mathrm{Recal}}$ étant calculé pour chaque instant k et non pas pour des instants T particuliers. Par suite l'estimation SOHE(k) à tout instant k a pour expression:

$$\mathrm{SOHE}(k)\mathrm{SOHE}_{\mathrm{modèle}} = \mathrm{SOHE}_{\mathrm{Recal}}(k)$$
$$= (1 - \alpha_{ic}(k)) \cdot \mathrm{SOHE}_{\mathrm{Modèle}}(k) + \alpha_{ic}(k) \cdot \mathrm{SOHE}_{\mathrm{Algorithme}}(k) \quad [19]$$

Dans ce cas, la valeur SOHE(k) de l'estimation, obtenue pour chaque instant k, peut ensuite être filtrée par un filtre du type passe-bas, ou par moyenne glissante, pour lisser les variations pouvant être apportées par l'algorithme d'estimation.
Bien que ne permettant pas de tirer systématiquement le meilleur parti des estimations réalisées à partir du modèle ou par le calcul ($\mathrm{SOHE}_{\mathrm{Algorithme}}$), cette variante de mise en œuvre présente cependant un caractère avantageux. En effet, l'estimation étant ici recalée à chaque instant k, cette variante de l'estimation de SOHE(k) permet avantageusement de limiter la divergence au cours du temps d'une estimation réalisée à partir d'un modèle, dès lors que cette estimation divergerait de manière importante dans le temps, et par là même de limiter l'apparition après un recalage de fluctuations importantes de la valeur estimée SOHE(k).

Selon une seconde variante du procédé selon l'invention, $SOHE_{Recal}$ prend une forme simplifié qui ne considère que l'estimation de SOHE réalisée par calcul direct ($SOHE_{Algorithme}$) et prend la forme suivante pour des instants T particuliers:

$$SOHE_{Recal}(T) = SOHE_{Algorithme}(T)$$

si

$$\alpha_{ic}(T) > lim_{Recal} \qquad\qquad [20]$$

Par suite, SOHE(k) est donné par la relation suivante:

$$SOHE(k) = SOHE_{modèle}(k) - SOHE_{modèle}(T) + SOHE_{Algorithme}(T) \quad [21]$$

Les instants de recalage T sont dans ce cas des instants où l'algorithme a réalisé une bonne estimation, la bonne estimation se traduisant ici par $\alpha_{ic}(T) > lim_{Recal}$.

Le seuil $lim_{recal}$ est ici choisi suffisamment grand, égal à 97% par exemple, pour que le recalage ne se produise que si l'on est sûr du caractère exact de l'estimation.

En effet, le recalage étant ici réalisée seulement à partir de l'estimation $SOHE_{Algorithme}$, cette variante de l'estimation de SOHE(k) permet avantageusement de simplifier le calcul de l'estimée SOHE(k). En revanche elle présente l'inconvénient relatif d'être susceptible de soumettre l'estimation SOHE(k) à des sauts parfois assez importants après recalage.

## Revendications

1. Procédé pour estimer, à un instant k, l'état de santé SOHE(k) d'une batterie d'accumulateurs installée dans un équipement et destinée à alimenter ledit équipement en énergie électrique, la valeur SOHE(k) étant déterminée par la relation suivante :

$$SOHE(k) = SOHE_{modèle}(k) - \alpha_{ic}(T) \cdot \left( SOHE_{modèle}(T) - SOHE_{Algorithme}(T) \right)$$

où :

- $SOHE_{modèle}$ est un modèle d'évolution au cours du temps de l'état de santé de la batterie à partir d'un état de santé à un instant initial ;
- $SOHE_{Algorithme}$ est un estimateur permettant de déterminer l'état de santé de la batterie à tout instant, à partir de mesures de grandeurs électriques relatives au fonctionnement de la batterie faites audit instant, l'instant T étant un instant de recalage, antérieur à l'instant k ;
- le coefficient $\alpha_{ic}(T)$ est l'indice de confiance attribué à la valeur fournie par l'estimateur $SOHE_{Algorithme}$ à l'instant T de recalage ; le procédé étant **caractérisé en ce que** le coefficient $\alpha_{ic}$ est défini à l'instant k par la relation suivante :

$$\alpha_{ic}(k) = f\left( \frac{dSOHE_{Algorithme}}{SOHE_{Algorithme}} \right)$$

où $dSOHE_{Algorithme}$ correspond à l'erreur théorique commise sur le calcul de $SOHE_{Algorithme}$ compte tenu de la précision des capteurs de mesures utilisés.

**2.** Procédé selon la revendication 1, **caractérisé en ce que** SOHE$_{modèle}$ est défini pour tout instant k par la relation suivante :

$$SOHE_{modèle}(k) = SOHE_{init}(0)\text{-dégradation}(k)$$

dans laquelle le terme SOHE$_{init}$(0) correspond à l'état de santé de la batterie à l'instant initial et le terme dégradation(k) correspond à l'altération, à l'instant k, de l'état de santé de la batterie par rapport à l'état de santé à l'instant initial.

**3.** Procédé selon la revendication 2, **caractérisé en ce que** le terme dégradation(k) est défini par la relation suivante :

$$\text{dégradation}(k) = \left( \sum_{i=1}^{P} \sum_{j=1}^{Q} \alpha_{i,j}^{\frac{1}{n}} * t_{i,j}(k) \right)^{n} + \left( \sum_{i=1}^{P} \sum_{j=1}^{Q} \beta_{i,j}^{\frac{1}{m}} * e_{i,j}(k) \right)^{m}$$

où les indices i et j sont associés respectivement à P valeurs de température de la batterie dans P états et à Q valeurs d'état de charge dans Q états, les couples (i, j) constituant P·Q états (température, état de charge) ; où $t_{i,j}$ est le laps de temps passé par la batterie, entre l'instant initial et l'instant k considéré, dans l'état (i, j) et où $e_{i,j}$ est l'énergie déchargée par la batterie, entre ce même instant initial et l'instant k, dans ce même état (i, j) ; les valeurs $t_{i,j}$ et $e_{i,j}$ étant réactualisées de manière périodique, depuis l'instant initial, durant les périodes où la batterie est en décharge.

**4.** Procédé selon l'une quelconque des revendications 1 à 3, **caractérisé en ce que** SOHE$_{Algorithme}$(k) est défini par la relation suivante :

$$SOHE_{Algorithme} = \frac{1}{Q_{BOL}} \frac{\left| \int_{t1}^{t2} I \, dt \right|}{|SOC_2 - SOC_1|}$$

où I représente le courant traversant la batterie, $t_1$ et $t_2$ respectivement les instants de début et de fin de mesure de I et SOC$_1$ et SOC$_2$ l'état de charge de la batterie aux instants respectifs $t_1$ et $t_2$; Q$_{BOL}$ représentant la capacité de la batterie à l'état neuf.

**5.** Procédé selon la revendication 4, **caractérisé en ce que** les états de charge SOC$_1$ et SOC$_2$ de la batterie aux instants respectifs $t_1$ et $t_2$ sont calculés soit à partir de mesures OCV1 et OCV2 de la tension à vide aux bornes de la batterie aux instants respectifs t1 et t2, lesdites mesures étant réalisées après une période d'inactivité de la batterie, soit par une estimation de l'état de charge par un estimateur.

**6.** Procédé selon l'une quelconque des revendications précédentes, **caractérisé en ce que** le coefficient $\alpha_{ic}$ est choisi de façon à prendre en compte au moins l'un des critères suivants :

a) plus l'erreur théorique est grande, plus $\alpha_{ic}$ est petit, $\alpha_{ic}$ étant une fonction décroissante de l'erreur ;
b) pour une erreur supérieure à une limite donnée, $\alpha_{ic}$ est forcé à zéro ;
c) tant que certaines conditions données, relatives aux mesures prises en compte dans l'estimation par calcul direct, ne sont pas remplies, $\alpha_{ic}$ est forcé à zéro, de façon à ce que l'estimateur ne soit pas pris en compte pour le calcul de SOHE.

**7.** Procédé selon la revendication 6, **caractérisé en ce que** les instants de recalage T sont des instants particuliers pour lesquels une condition portant sur la valeur de $\alpha_{ic}$(T) est remplie, indiquant que l'erreur théorique d'estimation réalisée par l'estimateur SOHE$_{Algorithme}$ est faible.

**8.** Procédé selon l'une quelconque des revendications 1 à 7, **caractérisé en ce que** SOHE(k) est défini, par la relation suivante :

$$SOHE(k) = SOHE_{modèle}(k) - SOHE_{modèle}(T) + SOHE_{Algorithme}(T) \, ;$$

les instants T étant des instants pour lesquels $\alpha_{ic}(T)$ est supérieur à une valeur de recalage $\lim_{recal}$ donnée.

**Patentansprüche**

1. Verfahren zur Schätzung des Gesundheitszustands SOHE(k) einer Batterie aus Akkumulatoren, die in eine Ausrüstung eingebaut ist und dazu bestimmt ist, die Ausrüstung mit elektrischer Energie zu versorgen, zu einem Zeitpunkt k, wobei der Wert SOHE(k) durch die folgende Gleichung bestimmt wird:

   $$SOHE(k) = SOHE_{Modell}(k) - \alpha_{ic}(T) \cdot (SOHE_{Modell}(T) - SOHE_{Algorithmus}(T))$$

   worin:

   - $SOHE_{Modell}$ ein Modell des zeitlichen Verlaufs des Gesundheitszustands der Batterie ausgehend von einem Gesundheitszustand zu einem Anfangszeitpunkt ist;
   - $SOHE_{Algorithmus}$ ein Schätzer ist, der es ermöglicht, den Gesundheitszustand der Batterie zu jedem Zeitpunkt anhand von zu diesem Zeitpunkt durchgeführten Messungen elektrischer Größen bezüglich des Betriebs der Batterie zu bestimmen, wobei der Zeitpunkt T ein Neueinstellungszeitpunkt ist, der vor dem Zeitpunkt k liegt;
   - der Koeffizient $\alpha_{ic}(T)$ der Vertrauensindex ist, der dem vom Schätzer $SOHE_{Algorithmus}$ zum Neueinstellungszeitpunkt T ausgegebenen Wert zugewiesen ist; wobei das Verfahren **dadurch gekennzeichnet ist, dass** der Koeffizient $\alpha_{ic}$ zum Zeitpunkt k durch die folgenden Gleichung definiert wird:

   $$\alpha_{ic}(k) = f\left(\frac{dSOHE_{Algorithmus}}{SOHE_{Algorithmus}}\right)$$

   worin $dSOHE_{Algorithmus}$ dem bei der Berechnung von $SOHE_{Algorithmus}$ unter Berücksichtigung der Genauigkeit der verwendeten Messfühler begangenen theoretischen Fehler entspricht.

2. Verfahren nach Anspruch 1, **dadurch gekennzeichnet, dass** $SOHE_{Modell}$ für jeden Zeitpunkt k durch die folgende Gleichung definiert wird:

   $$SOHE_{Modell}(k) = SOHE_{init}(0) - Degradation(k)$$

   wobei der Term $SOHE_{init}(0)$ dem Gesundheitszustand der Batterie zum Anfangszeitpunkt und der Term Degradation(k) der Verschlechterung des Gesundheitszustands der Batterie zum Zeitpunkt k in Bezug auf den Gesundheitszustand zum Anfangszeitpunkt entspricht.

3. Verfahren nach Anspruch 2, **dadurch gekennzeichnet, dass** der Term Degradation (k) durch die folgende Gleichung definiert wird:

   $$Degradation(k) = \left(\sum_{i=1}^{P}\sum_{j=1}^{Q}\alpha_{i,j}^{\frac{1}{n}} * t_{i,j}(k)\right)^{n} + \left(\sum_{i=1}^{P}\sum_{j=1}^{Q}\beta_{i,j}^{\frac{1}{m}} * e_{i,j}(k)\right)^{m}$$

   worin die Indizes i und j jeweils P Temperaturwerten der Batterie in P Zuständen und Q Ladezustandswerten in Q Zuständen zugeordnet sind, wobei die Paare (i, j) P.Q Zustände (Temperatur, Ladezustand) bilden;
   worin ti,j die von der Batterie zurückgelegte Zeitspanne zwischen dem Anfangszeitpunkt und dem betrachteten

**11**

Zeitpunkt k in dem Zustand (i, j) ist und worin ei,j die Energie ist, die von der Batterie zwischen demselben Anfangszeitpunkt und dem Zeitpunkt k in demselben Zustand (i, j) entladen wurde;

wobei die Werte ti,j et ei,j vom Anfangszeitpunkt an während der Zeiträume, zu denen sich die Batterie entlädt, regelmäßig aktualisiert werden.

**4.** Verfahren nach einem der Ansprüche 1 bis 3, **dadurch gekennzeichnet, dass** $SOHE_{Algorithmus}(k)$ durch die folgende Gleichung definiert wird:

$$SOHE_{Algorithmus} = \frac{1}{Q_{BOL}} \frac{\left| \int_{t1}^{t2} I \, dt \right|}{|SOC_2 - SOC_1|}$$

worin I den durch die Batterie fließenden Strom, $t_1$ und $t_2$ die Beginn- und Endezeitpunkte der Messung von I und $SOC_1$ und $SOC_2$ den Ladezustand der Batterie zu den jeweiligen Zeitpunkten $t_1$ und $t_2$ darstellen; wobei $Q_{BOL}$ die Kapazität der Batterie im Neuzustand darstellt.

**5.** Verfahren nach Anspruch 4, **dadurch gekennzeichnet, dass** die Ladezustände $SOC_1$ und $SOC_2$ der Batterie zu den jeweiligen Zeitpunkten $t_1$ und $t_2$ entweder anhand von Messungen OCV1 und OCV2 der Leerlaufspannung an den Klemmen der Batterie zu den jeweiligen Zeitpunkten $t_1$ und $t_2$ berechnet werden, wobei die Messungen nach einem Inaktivitätszeitraum der Batterie ausgeführt werden, oder durch eine Schätzung des Ladezustands durch einen Schätzer.

**6.** Verfahren nach einem der vorhergehenden Ansprüche, **dadurch gekennzeichnet, dass** der Koeffizient $\alpha_{ic}$ so gewählt wird, dass mindestens eines der folgenden Kriterien berücksichtigt wird:

a) je größer der theoretische Fehler ist, desto kleiner ist $\alpha_{ic}$, wobei $\alpha_{ic}$ eine fallende Fehlerfunktion ist;
b) bei einem Fehler oberhalb eines gegebenen Grenzwerts wird $\alpha_{ic}$ auf null gesetzt;
c) solange bestimmte gegebene Bedingungen bezüglich der bei der Schätzung durch direkte Berechnung berücksichtigten Messungen nicht erfüllt sind, wird $\alpha_{ic}$ auf null gesetzt, so dass der Schätzer bei der Berechnung von SOHE nicht berücksichtigt wird.

**7.** Verfahren nach Anspruch 6, **dadurch gekennzeichnet, dass** die Neueinstellungszeitpunkte T besondere Zeitpunkte sind, für die eine den Wert von $\alpha_{ic}(T)$ betreffende Bedingung erfüllt ist, die angeben, dass der durch den Schätzer $SOHE_{Algorithmus}$ ausgeführte theoretische Schätzfehler gering ist.

**8.** Verfahren nach einem der Ansprüche 1 bis 7, **dadurch gekennzeichnet, dass** SOHE(k) durch die folgende Gleichung definiert wird:

$$SOHE(k) = SOHE_{Modell}(k) - SOHE_{Modell}(T) + SOHE_{Algorithmus}(T);$$

wobei die Zeitpunkte T Zeitpunkte sind, für die $\alpha_{ic}(T)$ größer als ein gegebener Neueinstellungswert $lim_{recal}$ ist.

**Claims**

**1.** Method for estimating, at an instant k, the state of health SOHE(k) of an accumulator battery installed in an item of equipment and intended to supply said item of equipment with electrical energy, the value SOHE(K) being determined by the following relation:

$$SOHE(k) = SOHE_{model}(k) - \alpha_{ic}(T) \cdot \left( SOHE_{model}(T) - SOHE_{algorithm}(T) \right)$$

in which:

- SOHE$_{model}$ is a model of trend over time of the state of health of the battery from a state of health at an initial instant;
- SOHE$_{algorithm}$ is an estimator making it possible to determine the state of health of the battery at any instant, from measurements of electrical quantities relating to the operation of the battery made at said instant, the instant T being a recalibration instant, prior to the instant k;
- the coefficient $\alpha_{ic}(T)$ is the index of trust assigned to the value supplied by the estimator SOHE$_{algorithm}$ at the recalibration instant T; the method being **characterized in that** the coefficient $\alpha_{ic}$ is defined at the instant k by the following relation:

$$\alpha_{ic}(k) = f\left(\frac{dSOHE_{algorithm}}{SOHE_{algorithm}}\right)$$

in which dSOHE$_{algorithm}$ corresponds to the theoretical error committed on the calculation of the SOHE$_{algorithm}$ given the accuracy of the measurement sensors used.

2. Method according to Claim 1, **characterized in that** SOHE$_{model}$ is defined for any instant k by the following relation:

$$SOHE_{model}(k) = SOHE_{init}(0) - degradation(k)$$

in which the term SOHE$_{init}$(0) corresponds to the state of health of the battery at the initial instant and the term degradation(k) corresponds to the alteration, at the instant k, of the state of health of the battery relative to the state of health at the initial instant.

3. Method according to Claim 2, **characterized in that** the term degradation(k) is defined by the following relation:

$$degradation\ (k) = \left(\sum_{i=1}^{P}\sum_{j=1}^{Q}\alpha_{i,j}^{\frac{1}{n}} * t_{i,j}(k)\right)^n + \left(\sum_{i=1}^{P}\sum_{j=1}^{Q}\beta_{i,j}^{\frac{1}{m}} * e_{i,j}(k)\right)^m$$

in which the indices i and j are associated respectively with P values of temperature of the battery in P states and with Q values of state of charge in Q states, the pairs (i, j) constituting P.Q states (temperature, state of charge);
in which ti,j is the period of time spent by the battery, between the initial instant and the instant k considered, in the state (i, j) and in which ei,j is the energy discharged by the battery, between this same initial instant and the instant k, in this same state (i, j); the values $t_{i,j}$ and $e_{i,j}$ being reupdated periodically, from the initial instant, during the periods in which the battery is discharging.

4. Method according to any one of Claims 1 to 3, **characterized in that** SOHE$_{algorithm}$ (k) is defined by the following relation:

$$SOHE_{algorithm} = \frac{1}{Q_{BOL}}\frac{\left|\int_{t1}^{t2} I\,dt\right|}{|SOC_2 - SOC_1|}$$

in which I represents the current passing through the battery, $t_1$ and $t_2$ respectively represent the instants of start and of end of measurement of I and SOC$_1$ and SOC$_2$ respectively represent the state of charge of the battery at the respective instants $t_1$ and $t_2$; Q$_{BOL}$ representing the capacity of the battery in the new state.

5. Method according to Claim 4, **characterized in that** the states of charge SOC$_1$ and SOC$_2$ of the battery at the respective instants $t_1$ and $t_2$ are calculated either from measurements OCV1 and OCV2 of the off-load voltage at the terminals of the battery at the respective instants t1 and t2, said measurements being made after a period of inactivity of the battery, or by an estimation of the state of charge by an estimator.

6.  Method according to any one of the preceding claims, **characterized in that** the coefficient $\alpha_{ic}$ is chosen so as to take into account at least one of the following criteria:

    a) the greater the theoretical error, the smaller $\alpha_{ic}$ becomes, $\alpha_{ic}$ being a decreasing function of the error;
    b) for an error greater than a given limit, $\alpha_{ic}$ is forced to zero;
    c) as long as certain given conditions, relating to the measurements taken into account in the estimation by direct calculation, are not fulfilled, $\alpha_{ic}$ is forced to zero, so that the estimator is not taken into account for the calculation of SOHE.

7.  Method according to Claim 6, **characterized in that** the recalibration instants T are particular instants for which a condition relating to the value of $\alpha_{ic}(T)$ is fulfilled, indicating that the theoretical estimation error made by the estimator $SOHE_{algorithm}$ is low.

8.  Method according to any one of Claims 1 to 7, **characterized in that** SOHE(k) is defined by the following relation:

$$SOHE(k) = SOHE_{model}(k) - SOHE_{model}(T) + SOHE_{algorithm}(T);$$

the instants T being instants for which $\alpha_{ic}(T)$ is greater than a given recalibration value $lim_{recal}$.

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3009093

- JP 2016070682 A